# EUROPÄISCHE PATENTSCHRIFT

(11) **EP 1 360 881 B1**
(45) Veröffentlichungstag und Bekanntmachung des Hinweises auf die Patenterteilung: **21.07.2004**
(21) Anmeldenummer: 02703496.6
(22) Anmeldetag: 22.01.2002
(51) Int. Cl.: H05K 3/06, H05K 1/02

(54) **VERFAHREN ZUR HERSTELLUNG VON VERDRAHTUNGEN MIT GROBEN LEITERSTRUKTUREN UND MINDESTENS EINEM BEREICH MIT FEINEN LEITERSTRUKTUREN**
METHOD FOR PRODUCING WIRINGS WITH ROUGH CONDUCTING STRUCTURES AND AT LEAST ONE AREA WITH FINE CONDUCTING STRUCTURES
PROCEDE DE REALISATION DE CABLAGES COMPRENANT DES STRUCTURES CONDUCTRICES GROSSIERES ET AU MOINS UNE ZONE POURVUE DE STRUCTURES CONDUCTRICES FINES

(30) Priorität: 12.02.2001 DE 10106399
(43) Veröffentlichungstag der Anmeldung: 12.11.2003
(73) Patentinhaber: SIEMENS AKTIENGESELLSCHAFT, 80333 München (DE)
(72) Erfinder: HEERMAN, Marcel, B-9200 Merelbeke (BE); VAN PUYMBROECK, Jozef, B-8020 Oostkamp (BE); ROELANTS, Eddy, B-8000 Bruegge (BE)
(86) Internationale Anmeldenummer: PCT/DE2002/000190
(87) Internationale Veröffentlichungsnummer: WO 2002/065822

(56) Entgegenhaltungen:
- EP-A- 0 062 300
- EP-A- 0 602 258
- WO-A-00/04750
- WO-A-98/15159
- GB-A- 1 335 612
- US-A- 4 527 041

## Beschreibung

Aus der EP-A-0 602 258 ist ein Verfahren zur Herstellung von Leiterplatten mit groben Leiterstrukturen bekannt, wobei jedoch ein abgegrenzter Bereich dieser Leiterplatten eine sehr hohe Verdrahtungsdichte erhalten soll. Dies wird durch eine zusätzliche Verdrahtungslage erreicht, die nur in dem abgegrenzten Bereich aufgebracht wird und mit der darunter liegenden Verdrahtungslage über Durchkontaktierungen verbunden ist.

Aus der EP-A-0 062 300 ist ein Verfahren zur Herstellung von leiterplatten bekannt, bei welchem ein ganzflächig auf eine Metallschicht aufgebrachtes metallisches Ätzresist mittels Laserstrahlung selektiv in den nicht den Leiterstrukturen entsprechenden Bereichen wieder entfernt wird und die Leiterstrukturen durch Abätzen der derart freigelegten Metallschicht gebildet werden.

Aus der WO-A-00/04750 ist ein Verfahren zur Herstellung von Leiterplatten mit groben Leiterstrukturen und mindestens einem Bereich mit feinen Leiterstrukturen bekannt, bei welchem die groben Leiterstrukturen und die feinen Leiterstrukturen in einem gemeinsamen Ätzprozess aus einer Metallschicht herausgeätzt werden. Bei diesem gemeinsamen Ätzprozess wird im Bereich der groben Leiterstrukturen ein mittels Photolithographie strukturiertes Ätzresist und im Bereich der feinen Leiterstrukturen ein mit Hilfe eines Laserstrahls strukturiertes Ätzresist verwendet. Gemäß einer ersten Ausführungsform des bekannten Verfahrens wird auf die Metallschicht ein Photoresist aufgebracht und mittels Photolithographie derart strukturiert, dass es im Bereich der groben Leiterstrukturen ein negatives Muster dieser groben Leiterstrukturen aufweist und dass es den gesamten Bereich der feinen Leiterstrukturen abdeckt. Im Bereich der feinen Leiterstrukturen wird dann das Photoresist mit Hilfe eines Laserstrahls derart strukturiert, dass es das negative Muster der feinen Leiterstrukturen aufweist. Das Ätzresist wird dann beispielsweise durch die außen stromlose Abscheidung von Zinn in einem Arbeitsgang auf die groben und die feinen Leiterstrukturen aufgebracht, so dass nach der Entfernung des Photoresists der gemeinsame Atzprozess durchgeführt werden kann. Gemäß einer zweiten Ausführungsform des bekannten Verfahrens wird das auf die Metallschicht aufgebrachte Photoresist mittels Photolithographie derart strukturiert, dass es im Bereich der groben Leiterstrukturen ein negatives Muster dieser groben Leiterstrukturen aufweist. Das Ätzresist wird dann auf die groben Leiterstrukturen und auf den gesamten Bereich der feinen Leiterstrukturen aufgebracht. Nach der Entfernung des Photoresists wird dann das Ätzresist im Bereich der feinen Leiterstrukturen mit Hilfe eines Laserstrahls derart strukturiert, dass es das Muster der feinen Leiterstrukturen aufweist. Die Herstellung der groben Leiterstrukturen und der feinen Leiterstrukturen erfolgt dann wieder in einem gemeinsamen Ätzprozess.

Der im Anspruch 1 angegebenen Erfindung liegt das Problem zugrunde, das aus der WO-A-00/04750 bekannte Verfahren zur Herstellung von Leiterplatten mit groben Leiterstrukturen und mit mindestens einem Bereich mit feinen Leiterstrukturen derart zu verbessern, dass es mit geringerem Zeitaufwand durchgeführt werden kann.

Der Erfindung liegt die Erkenntnis zugrunde, dass bei einer Kombination von konventioneller Photoätztechnik für die Herstellung der groben Leiterstrukturen und der Laserstrukturierung für die Herstellung der feinen Leiterstrukturen jeweils große Bereiche des Photoresists, des Ätzresists und der Metallschicht rasch durch die Schritte Belichten und Entwickeln des Photoresists, Strippen des Ätzresists und Ätzen der Metallschicht entfernt werden können. Da die Laserstrukturierung des Ätzresists im Bereich der feinen Leiterstrukturen ohnehin rasch durchgeführt werden kann, ergibt sich insgesamt ein minimaler Zeitaufwand.

Vorteilhafte Ausgestaltungen des erfindungsgemäßen Verfahrens sind in den Ansprüchen 2 bis 8 angegeben.

Obwohl als Ätzresist prinzipiell auch organische Resists verwendet werden können, wird gemäß Anspruch 2 ein metallisches Ätzresist bevorzugt. Das Aufbringen dieses metallischen Ätzresists auf die Metallschicht kann dann rasch und mit geringem Aufwand gemäß Anspruch 3 durch außen stromlose oder galvanische Metallabscheidung vorgenommen werden. Dabei hat sich gemäß Anspruch 4 die Verwendung von Zinn oder Zinn-Blei als Ätzresist besonders bewährt.

Die Ausgestaltung nach Anspruch 5 ermöglicht die Herstellung von Durchkontaktierungen sowohl im Bereich der groben Leiterstrukturen als auch im Bereich der feinen Leiterstrukturen.

Die Weiterbildung nach Anspruch 6 ermöglicht einen besonders einfachen Schutz des Ätzresists im Bereich der Durchkontaktierungen.

Falls das Ätzresist bei der weiteren Behandlung der Verdrahtung stört, wird es gemäß Anspruch 7 wieder entfernt. In diesem Fall können dann beispielsweise andere Metallschichten auf die groben und die feinen Leiterstrukturen aufgebracht werden.

Die Ausgestaltung nach Anspruch 8 ermöglicht auf einfache Weise die Herstellung von Verdrahtungen mit zwei oder auch mit mehreren Verdrahtungslagen, die wiederum grobe und feine Leiterstrukturen aufweisen.

Im folgenden werden Ausführungsbeispiele der Erfindung anhand der Zeichnung näher erläutert.

Es zeigen
- Figur 1: bis Figur 9 verschiedene Verfahrensstadien eines Verfahrens zur Herstellung von Leiterplatten mit groben Leiterstrukturen und einem Bereich mit feinen Leiterstrukturen und
- Figur 10: bis Figur 18 verschiedene Verfahrensstadien bei der Herstellung von Leiterplatten mit zwei Verdrahtungslagen, die jeweils grobe Leiterstrukturen und einen Bereich mit feinen Leiterstrukturen aufweisen.

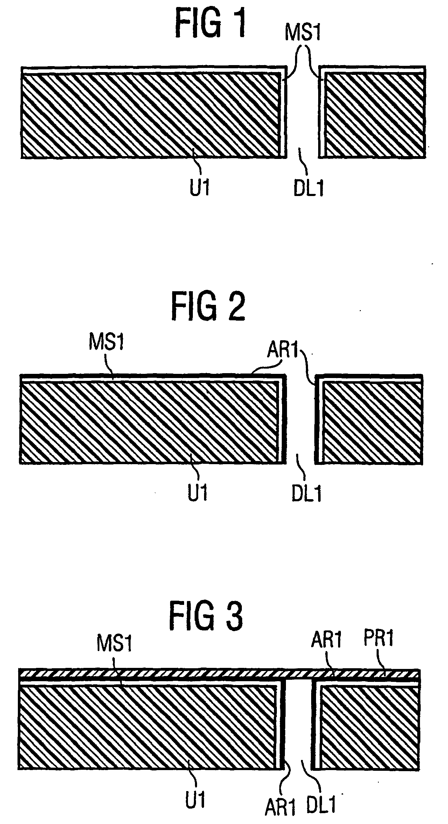

Gemäß Figur 1 wird auf eine im Schnitt dargestellte, elektrisch isolierende Unterlage U1 eine erste Metallschicht MS1 aufgebracht, welche auch die Wandung eines in die Unterlage U1 eingebrachten Durchkontaktierungsloches DL1 bedeckt. Bei der Unterlage U1 handelt es sich beispielsweise um ein übliches Basismaterial für Leiterplatten. Die erste Metallschicht MS1 wird beispielsweise durch außen stromlose und anschließende galvanische Abscheidung von Kupfer auf die Unterlage U1 aufgebracht. Es ist auch möglich, von einer kupferkaschierten Unterlage U1 auszugehen, in welche dann das Durchkontaktierungsloch DL1 gebohrt wird, worauf die Wandung dieses Durchkontaktierungsloches DL1 durch außen stromlose und galvanische Metallabscheidung metallisiert wird. Bei der Metallisierung der Durchkontaktierungslöcher DL1 wird die Kupferkaschierung entsprechend verstärkt.

Gemäß Figur 2 wird auf die erste Metallschicht MS1 ein Ätzresist AR1 aufgebracht, welches auch die Metallschicht MS1 im Durchkontaktierungsloch DL1 bedeckt. Bei dem Ätzresist AR1 handelt es sich beispielsweise um Zinn, welches durch außen stromlose Metallabscheidung aufgebracht wird.

Gemäß Figur 3 wird dann auf der Oberseite der Unterlage U1 ein erstes Photoresist PR1 auf das Ätzresist AR1 aufgebracht. Es ist zu erkennen, dass dieses erste Photoresist PR1 die obere Öffnung des Durchkontaktierungsloches DL1 abdeckt. Das erste Photoresist PR1 wird beispielsweise in Form einer Folie auflaminiert.

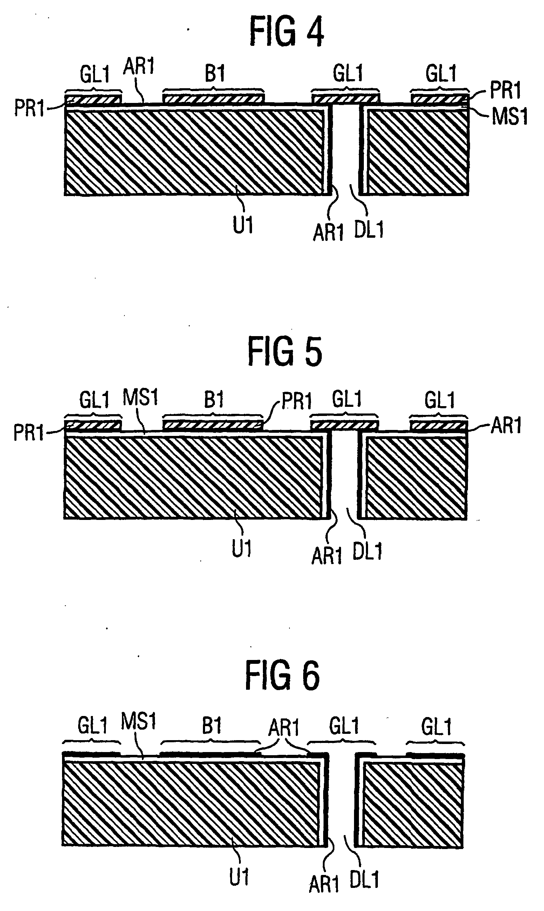

Das Photoresist PR1 wird dann im nächsten Schritt durch Belichten und Entwickeln derart strukturiert, dass das mit GL1 bezeichneten Muster der späteren groben Leiterstrukturen und ein mit B1 bezeichneter Bereich der späteren feinen Leiterstrukturen abgedeckt sind. Diese Strukturierung des Photoresists PR1 mittels Photolithographie ist aus Figur 4 ersichtlich.

Nach der Strukturierung des Photoresists PR1 wird gemäß Figur 5 das Ätzresist AR1 in den freiliegenden Bereichen entfernt. Es ist zu erkennen, dass das Ätzresist AR1 im Bereich des Durchkontaktierungsloches DL1 nicht entfernt wird, da es durch das Photoresist und eine entsprechende nicht dargestellte Abdichtung des Durchkontaktierungsloches DL1 von unten her geschützt ist. Die auch als Strippen bezeichnete Entfernung des Ätzresists AR1 erfolgt im geschilderten Ausführungsbeispiel durch einen handelsüblichen Zinn-Stripper, der jedoch das erste Photoresist PR1 nicht angreifen darf.

Im nächsten Schritt wird dann gemäß Figur 6 das erste Photoresist PR1 vollständig entfernt. Der hierzu verwendete handelsübliche Resist-Stripper darf das erste Ätzresist AR1 dabei nicht angreifen. Es ist ersichtlich, dass das verbliebene erste Ätzresist AR1 die späteren groben Leiterstrukturen GL1, die Wandung des Durchkontaktierungsloches DL1 und den gesamten Bereich B1 der späteren feinen Leiterstrukturen abdeckt.

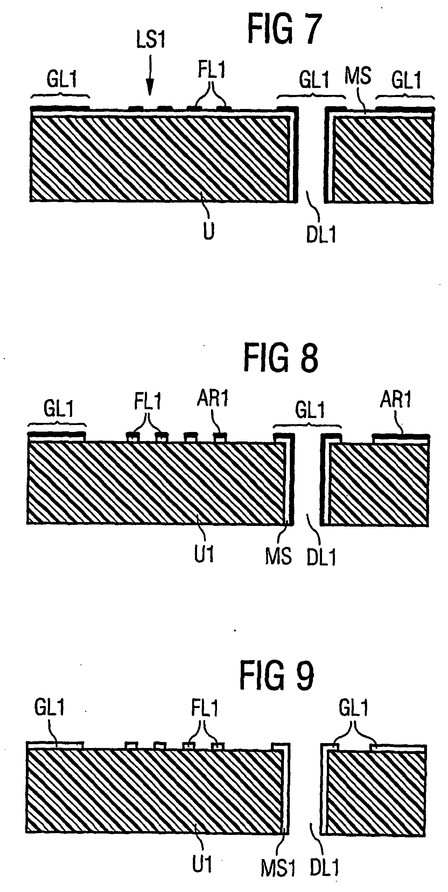

In diesem Bereich B1 wird dann gemäß Figur 7 das erste Ätzresist AR1 mit Hilfe eines Laserstrahls LS1 derart strukturiert, dass es das Muster der späteren feinen Leiterstrukturen FL1 aufweist.

Nach der Laserstrukturierung im Bereich B1 (vgl. Figur 6) wird dann gemäß Figur 8 zur Bildung der groben Leiterstrukturen GL1 und der feinen Leiterstrukturen FL1 in einem gemeinsamen Ätzprozess die Metallschicht MS1 in den nicht durch das Ätzresist AR1 geschützten Bereichen bis zur Oberfläche der Unterlage U1 weggeätzt.

Im letzten Schritt wird dann gemäß Figur 9 das verbliebene Ätzresist AR1 entfernt. Für diesen Vorgang wird wieder der bereits erwähnte Zinn-Stripper verwendet.

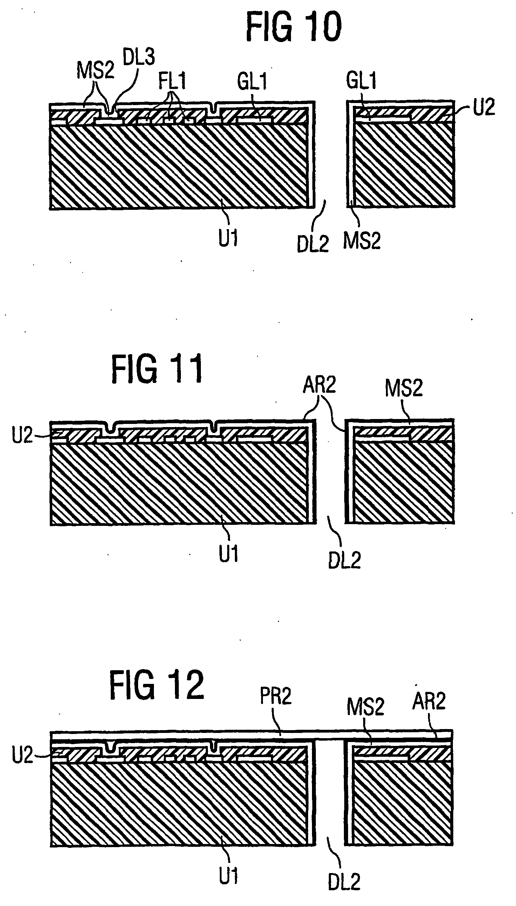

Bei der Herstellung von Leiterplatten mit zwei Verdrahtungslagen wird die erste Verdrahtungslage mit groben Leiterstrukturen GL1 und feinen Leiterstrukturen FL1 entsprechend den vorstehend anhand der Figuren 1 bis 9 geschilderten Schritte hergestellt. Eine entsprechende erste Verdrahtungslage ist aus Figur 10 ersichtlich, wobei die groben Leiterstrukturen GL1 und die feinen Leiterstrukturen FL2 von den in Figur 9 gezeigten Strukturen etwas abweichen. Auf die erste Verdrahtungslage wird dann eine zweite, elektrisch isolierende Unterlage U2 aufgebracht, beispielsweise durch Vorhanggießen und nachfolgendes Aushärten. An den Stellen späterer Durchkontaktierungen werden dann in die zweite Unterlage U2 beispielsweise durch Laserbohren Durchkontaktierungslöcher DL2 und DL3 eingebracht. Beim Aufbringen einer zweiten Metallschicht MS2 auf die zweite Unterlage U2 werden dann auch die Wandungen der Durchkontaktierungslöcher DL2 und DL3 metallisiert, so wie es aus Figur 10 ersichtlich ist. Es ist auch erkennbar, dass bei den Durchkontaktierungslöchern DL3 die zweite Metallschicht MS2 einen Kontakt zu den darunter liegenden Leiterstrukturen der ersten Verdrahtungslage herstellt.

Im nächsten Schritt wird dann gemäß Figur 11 ein zweites Ätzresist AR2 auf die zweite Metallschicht MS2 aufgebracht. Danach erfolgt gemäß Figur 12 das Aufbringen eines zweiten Photoresists PR2, welches auch die Öffnungen der Durchkontaktierungslöcher DL2 und DL3 überspannt.

Nach der Strukturierung des zweiten Photoresists PR2 durch Belichten und Entwickeln sind dann gemäß Figur 13 nur noch das Muster der späteren groben Leiterstrukturen GL2 und der gesamte Bereich B2 der späteren feinen Leiterstrukturen der zweiten Verdrahtungslage abgedeckt.

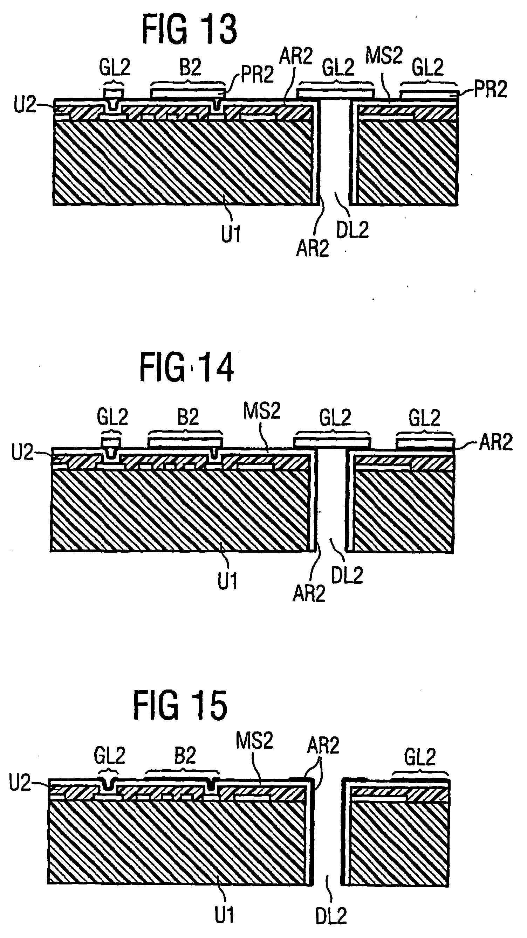

Anschließend wird dann gemäß Figur 14 das nicht vom zweiten Photoresist PR2 geschützte zweite Ätzresist AR2 entfernt, worauf gemäß Figur 15 das zweite Photoresist PR2 vollständig entfernt wird.

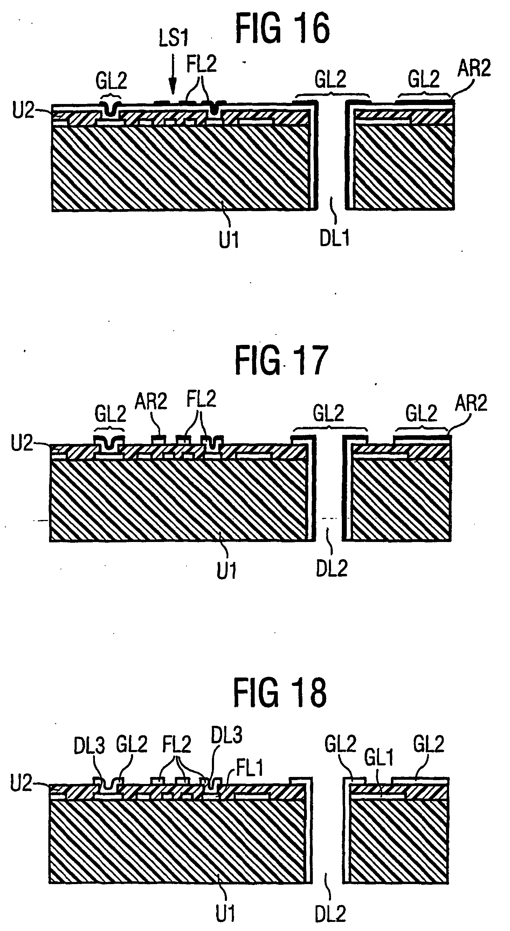

Im nächsten Schritt wird dann gemäß Figur 16 im Bereich B2 das zweite Atzresist AR2 mit Hilfe eines Laserstrahls LS2 derart strukturiert, dass es das Muster der späteren zweiten feinen Leiterstrukturen FL2 der zweiten Verdrahtungslage aufweist.

Nach der Laserstrukturierung im Bereich B2 (vgl. Figur 15) wird dann gemäß Figur 17 zur Bildung der groben Leiterstrukturen GL2 und der feinen Leiterstrukturen FL2 der zweiten Verdrahtungslage in einem gemeinsamen Ätzprozess die zweite Metallschicht MS2 in den nicht durch das zweite Ätzresist AR2 geschützten Bereichen bis zur Oberfläche der zweiten Unterlage U2 weggeätzt. Im letzten Schritt wird dann das verbliebene zweite Ätzresist AR2 entfernt. Die resultierende Leiterplatte mit zwei Verdrahtungslagen ist aus Figur 18 ersichtlich.

## Patentansprüche

1. Verfahren zur Herstellung von Verdrahtungen mit groben Leiterstrukturen (GL1; GL2) und mit mindestens einem abgegrenzten Bereich (B1; B2) mit feinen Leiterstrukturen (FL1; FL2), mit folgenden Schritten:
a) auf eine elektrisch isolierende Unterlage (U1; U2) wird eine Metallschicht (MS1; MS2) aufgebracht;
b) auf die Metallschicht (MS1; MS2) wird ein Atzresist (AR1; AR2) aufgebracht;
c) auf das Atzresist (AR1; AR2) wird ein Photoresist (PR1; PR2) aufgebracht;
d) das Photoresist (PR1; PR2) wird mittels Photolithographie derart strukturiert, dass das Muster der groben Leiterstrukturen (GL1; GL2) und der Bereich (B1; B2) der feinen Leiterstrukturen (FL1; FL2) abgedeckt sind;
e) das Atzresist (AR1; AR2) wird in den nicht vom Photoresist (PR1; PR2) bedeckten Bereichen entfernt;
f) das Photoresist (PR1; PR2) wird entfernt;
g) das Ätzresist (AR1; AR2) wird mit Hilfe eines Laserstrahls (LS1; LS2) derart strukturiert, dass es das Muster der feinen Leiterstrukturen (FL1; FL2) aufweist;
h) zur Bildung der groben Leiterstrukturen (GL1; GL2) und der feinen Leiterstrukturen (FL1; FL2) werden in einem gemeinsamen Ätzprozess die nicht durch ein Ätzresist (AR1; AR2) geschützten Bereiche der Metallschicht (MS1; MS2) bis zur Oberfläche der Unterlage (U1; U2) weggeätzt.

2. Verfahren nach Anspruch 1, **dadurch gekennzeichnet, dass** in Schritt b) ein metallisches Ätzresist (AR1; AR2) auf die Metallschicht (MS1; MS2) aufgebracht wird.

3. Verfahren nach Anspruch 2, **dadurch gekennzeichnet, dass** das metallische Ätzresist (AR1; AR2) durch außen stromlose oder galvanische Metallabscheidung auf die Metallschicht (MS1; MS2) aufgebracht wird.

4. Verfahren nach einem der Ansprüche 1 bis 3, **dadurch gekennzeichnet, dass** als Ätzresist (AR1; AR2) Zinn oder Zinn-Blei verwendet wird.

5. Verfahren nach einem der Ansprüche 1 bis 4, **dadurch gekennzeichnet, dass** im Bereich der groben Leiterstrukturen (GL1; GL2) und/oder im Bereich der feinen Leiterstrukturen (FL1; FL2) Durchkontaktierungslöcher (DL1; DL2, DL3) in die Unterlage (U1; U2) eingebracht werden und dass auf die Wandungen der Durchkontaktierungslöcher (DL1; DL2, DL3) in den Schritten a) und b) die Metallschicht (MS1; MS2) und das Ätzresist (AR1; AR2) aufgebracht werden.

6. Verfahren nach Anspruch 5, **dadurch gekennzeichnet, dass** im Schritt c) das Photoresist (PR1; PR2) derart aufgebracht wird, dass die Öffnungen der Durchkontaktierungslöcher (DL1; DL2, DL3) mit Photoresist (PR1; PR2) abgedeckt werden.

7. Verfahren nach einem der Ansprüche 1 bis 6, **dadurch gekennzeichnet, dass** das Atzresist (AR1; AR2) nach dem Schritt h) vollständig entfernt wird.

8. Verfahren nach einem der Ansprüche 1 bis 7, **dadurch gekennzeichnet, dass** auf einer ersten elektrisch isolierenden Unterlage (U1) eine erste Verdrahtungslage mit ersten groben Leiterstrukturen (GL1) und/oder ersten feinen Leiterstrukturen (FL1), gebildet wird, dass auf die erste Verdrahtungslage eine zweite elektrisch isolierende Unterlage (U2) aufgebracht wird, dass in die zweite Unterlage (U2) Durchkontaktierungslöcher (DL3) eingebracht werden und dass dann auf der zweiten Unterlage (U2) entsprechend den Schritten a) bis h) eine zweite Verdrahtungslage mit zweiten groben Leiterstrukturen (GL2) und zweiten feinen Leiterstrukturen (FL2) gebildet wird, wobei auf die Wandungen der Durchkontaktierungslöcher (DL3) in den Schritten a) und b) eine Metallschicht (MS2) und ein Ätzresist (AR2) aufgebracht werden.

## Claims

1. Method for producing wiring arrangements having coarse conductor structures (GL1; GL2) and having at least one delimited region (B1; B2) having fine conductor structures (FL1; FL2), having the following steps:
a) a metal layer (MS1; MS2) is applied to an electrically insulating substrate (U1; U2);
b) an etching resist (AR2; AR2) is applied to the metal layer (MS1; MS2);
c) a photoresist (PR1; PR2) is applied to the etching resist (AR1; AR2);
d) the photoresist (PR1; PR2) is patterned by means of photolithography in such a way that the pattern of the coarse conductor structures (GL1; GL2) and the region (B1; B2) of the fine conductor structures (FL1; FL2) are covered;
e) the etching resist (AR1; AR2) is removed in the regions not covered by the photoresist (PR1; PR2);
f) the photoresist (PR1; PR2) is removed;
g) the etching resist (AR1; AR2) is patterned with the aid of a laser beam (LS1; LS2) in such a way that it has the pattern of the fine conductor structures (FL1; FL2);
h) in order to form the coarse conductor structures (GR1; GR2) and the fine conductor structures (FL1; FL2), those regions of the metal layer (MS1; MS2) which are not protected by an etching resist (AR1; AR2) are etched away as far as the surface of the substrate (U1; U2) in a common etching process.

2. Method according to Claim 1, **characterized in that** a metallic etching resist (AR1; AR2) is applied to the metal layer (MS1; MS2) in step b).

3. Method according to Claim 2, **characterized in that** the metallic etching resist (AR1; AR2) is applied to the metal layer (MS1; MS2) by externally electroless or electrical metal deposition.

4. Method according to one of Claims 1 to 3, **characterized in that** tin or tin-lead is used as the etching resist (AR1; AR2).

5. Method according to one of Claims 1 to 4, **characterized in that**, in the region of the coarse conductor structures (GL1; GL2) and/or in the region of the fine conductor structures (FL1; FL2), plated-through holes (DL1; DL2, DL3) are introduced into the substrate (U1; U2), and **in that** the metal layer (MS1; MS2) and the etching resist (AR1; AR2) are applied to the walls of the plated-through holes (DL1; DL2, DL3) in steps a) and b).

6. Method according to Claim 5, **characterized in that**, in step c), the photoresist (PR1; PR2) is applied in such a way that the openings of the plated-through holes (DL1; DL2, DL3) are covered with photoresist (PR1; PR2).

7. Method according to one of Claims 1 to 6, **characterized in that** the etching resist (AR1; AR2) is completely removed after step h).

8. Method according to one of Claims 1 to 7, **characterized in that** a first wiring layer having first coarse conductor structures (GL1) and/or first fine conductor structures (FL1) is formed on a first electrically insulating substrate (U1), **in that** a second electrically insulating substrate (U2) is applied to the first wiring layer, **in that** plated-through holes (DL3) are introduced into the second substrate (U2), and **in that** a second wiring layer having second coarse conductor structures (GL2) and second fine conductor structures (FL2) is then formed on the second substrate (U2) in accordance with steps a) to h), a metal layer (MS2) and an etching resist (AR2) being applied to the walls of the plated-through holes (DL3) in steps a) and b).

## Revendications

1. Procédé de réalisation de câblages comprenant des structures conductrices grossières (GL1 ; GL2) et au moins une zone délimitée (B1 ; B2) pourvue de structures conductrices fines (FL1 ; FL2), comprenant les étapes suivantes :
a) une couche métallique (MS1 ; MS2) est appliquée sur un support électriquement isolant (U1 ; U2) ;
b) un résist contre gravure (AR1 ; AR2) est appliqué sur la couche métallique (MS1 ; MS2) ;
c) un photorésist (PR1 ; PR2) est appliqué sur le résist contre gravure (AR1 ; AR2) ;
d) le photorésist (PR1 ; PR2) est structuré par photolithographie de manière à masquer le motif des structures conductrices grossières (GL1 ; GL2) et la zone (B1 ; B2) des structures conductrices fines (FL1 ; FL2) ;
e) le résist contre gravure (AR1 ; AR2) est éliminé dans les zones qui ne sont pas couvertes par le photorésist (PR1 ; PR2) ;
f) le photorésist (PR1 ; PR2) est éliminé ;
g) le résist contre gravure (AR1 ; AR2) est structuré à l'aide d'un rayon laser (LS1 ; LS2) de manière à présenter le motif des structures conductrices fines (FL1 ; FL2) ;
h) les zones de la couche métallique (MS1 ; MS2) qui ne sont pas protégées par un résist contre gravure (AR1 ; AR2) sont éliminées par attaque chimique jusqu'à la surface du substrat (U1 U2), au cours d'un processus de gravure commun, pour former les structures conductrices grossières (GL1 ; GL2) et les structures conductrices fines (FL1 ; FL2)

2. Procédé selon la revendication 1, **caractérisé en ce qu'**un résist métallique contre gravure (AR1 ; AR2) est appliqué sur la couche métallique (MS1 ; MS2) dans l'étape b).

3. Procédé selon la revendication 2, **caractérisé en ce que** le résist métallique contre gravure (AR1 ; AR2) est appliquée sur la couche métallique (MS1 ; MS2) par dépôt extérieur non-électrique ou galvanique de métal.

4. Procédé selon l'une des revendications 1 à 3, **caractérisé en ce que** l'on utilise de l'étain ou de l'étain-plomb en tant que résist contre gravure (AR1 ; AR2).

5. Procédé selon l'une des revendications 1 à 4, **caractérisé en ce que** des trous métallisés (DL1 ; DL2, DL3) sont faits dans le substrat (U1 ; U2) dans la zone des structures conductrices grossières (GL1 ; GL2) et/ou dans la zone des structures conductrices fines (FL1 ; FL2) et **en ce que** la couche métallique (MS1 ; MS2) et le résist métallique contre gravure (AR1 ; AR2) sont appliqués sur les parois des trous métallisés (DL1 ; DL2 ; DL3) dans les étapes a) et b).

6. Procédé selon la revendication 5, **caractérisé en ce que** le photorésist (PR1 ; PR2) est appliqué, dans l'étape c), de manière à ce que les ouvertures des trous métallisés (DL1 ; DL2 ; DL3) soient masquées par le photorésist (PR1 ; PR2).

7. Procédé selon l'une des revendications 1 à 6, **caractérisé en ce que** le résist contre gravure (AR1 ; AR2) est totalement éliminé après l'étape h).

8. Procédé selon l'une des revendications 1 à 7, **caractérisé en ce qu'**une première couche de câblage comprenant des premières structures conductrices grossières (GL1) et/ou des premières structures conductrices fines (FL1) est formée sur un premier substrat électriquement isolant (U1), **en ce qu'**un second substrat électriquement isolant (U2) est appliqué sur la première couche de câblage, **en ce que** des trous métallisés (DL3) sont faits dans le second substrat (U2) et **en ce qu'**une seconde couche de câblage comprenant des secondes structures conductrices grossières (GL2) et des secondes structures conductrices fines (FL2) est formée sur le second substrat (U2) en suivant les étapes a) à h), une couche métallique (MS2) et un résist contre gravure (AR2) étant appliqués sur les parois des trous métallisés (DL3) dans les étapes a) et b).
